# EUROPEAN PATENT APPLICATION

(11) **EP 4 844 810 A1**
(43) Date of publication of application: **25.11.2026**
(21) Application number: 25761280.4
(22) Date of filing: 21.02.2025
(51) Int. Cl.: H01L 25/07, H01L 25/18

(54) **POWER MODULE AND SEMICONDUCTOR DEVICE**

(30) Priority: 27.02.2024 JP 2024027716
(71) Applicant: DAIKIN INDUSTRIES, LTD., Osaka-shi, Osaka 530-0001 (JP)
(72) Inventor: YOSHIMOTO, Akio, Osaka-shi, Osaka 530-0001 (JP); SAKAI, Shinji, Osaka-shi, Osaka 530-0001 (JP)
(74) Representative: Hoffmann Eitle
(86) International application number: PCT/JP2025/006032
(87) International publication number: WO 2025/182806

(57) **Abstract**

A first wiring member (11) has a mounting surface (15) on which a semiconductor element (2) is mounted and an exposed surface (16) exposed on a side opposite to the mounting surface (15). A second wiring member (12) is spaced apart from the first wiring member (11) in a direction orthogonal to a plate thickness direction of the first wiring member (11). A holding member (20) is disposed between the first wiring member (11) and the second wiring member (12) and holds the first wiring member (11) and the second wiring member (12). The holding member (20) includes a protruding portion (22). The protruding portion (22) protrudes from the exposed surface (16) toward an exposed surface (16) side in the plate thickness direction.

## Description

### Technical Field

The present disclosure relates to a power module and a semiconductor device.

### Background Art

Patent Literature 1 discloses a power module including a power semiconductor element, a ceramic substrate that is a circuit board on which the power semiconductor element is mounted, and a heat dissipation fin on which the ceramic substrate is mounted by using thermal grease.

### Citation List

### Patent Literature

PTL 1: Japanese Patent No. 6234630

### Summary of Invention

### Technical Problem

In the invention of Patent Literature 1, the ceramic substrate serving as an insulating heat dissipation member is disposed between the power semiconductor element and the heat dissipation fin. Therefore, there is a problem that when heat generated by the power semiconductor element is dissipated, heat dissipation performance decreases due to thermal resistance that occurs in the insulating heat dissipation member.

An object of the present disclosure is to make it easier to dissipate heat generated by a semiconductor element.

### Solution to Problem

A first aspect of the present disclosure is a power module including a semiconductor element (2); a first wiring member (11) that is a plate-shaped member having electric conductivity and has a mounting surface (15) on which the semiconductor element (2) is mounted and an exposed surface (16) exposed on a side opposite to the mounting surface (15); a second wiring member (12) that is a plate-shaped member having electric conductivity, is spaced apart from the first wiring member (11) in a direction orthogonal to a plate thickness direction of the first wiring member (11), and has an exposed surface (16) exposed on the same side as the exposed surface (16) of the first wiring member (11); a holding member (20) that has an insulating property, is disposed between the first wiring member (11) and the second wiring member (12), holds the first wiring member (11) and the second wiring member (12), and includes a protruding portion (22) that protrudes from the exposed surface (16) toward an exposed surface (16) side in the plate thickness direction; and a sealing material (36) that has an insulating property and covers at least the semiconductor element (2), the mounting surface (15) of the first wiring member (11), and the mounting surface (15) of the second wiring member (12).

According to the first aspect, heat generated by the semiconductor element (2) is directly dissipated from the exposed surface (16) of the first wiring member (11). This can lower thermal resistance. Furthermore, the presence of the protruding portion (22) makes it possible to secure a creepage distance for insulation between the first wiring member (11) and the second wiring member (12).

In the power module according to the first aspect, a second aspect of the present disclosure is arranged such that an end portion of the holding member (20) on a side where the mounting surface (15) of the first wiring member (11) is located is flush with the mounting surface (15) or is disposed on the exposed surface (16) side relative to the mounting surface (15).

According to the second aspect, it is possible to suppress occurrence of a situation where the holding member (20) causes a hindrance during wire bonding between the first wiring member (11) and the second wiring member (12). Furthermore, it is possible to reduce an amount of the holding member (20) used.

In the power module according to the first or second aspect, a third aspect of the present disclosure is arranged such that the protruding portion (22) has a shape tapered toward a tip of the protruding portion (22).

According to the third aspect, heat generated by the semiconductor element (2) is dissipated so as to expand outward along the tapered shape of the protruding portion (22). This can lower thermal resistance.

In the power module according to any one of the first to third aspects, a fourth aspect of the present disclosure further includes a connection terminal (13) that is integral with the first wiring member (11).

According to the fourth aspect, it is unnecessary to perform a step of connecting the first wiring member (11) and the connection terminal (13). This can achieve a reduction in the number of work steps.

In the power module according to the fourth aspect, a fifth aspect of the present disclosure is arranged such that the connection terminal (13) extends in the direction orthogonal to the plate thickness direction of the first wiring member (11), and the power module further includes an insulating member (25) that is provided on a side of the connection terminal (13) where the exposed surface (16) of the first wiring member (11) is located.

According to the fifth aspect, even in the configuration in which the connection terminal (13) extends in the direction orthogonal to the plate thickness direction of the first wiring member (11), the presence of the insulating member (25) on the side of the connection terminal (13) where the exposed surface (16) of the first wiring member (11) is located makes it possible to secure an insulation distance.

In the power module according to the fourth aspect, a sixth aspect of the present disclosure is arranged such that the connection terminal (13) extends from the mounting surface (15) of the first wiring member (11) toward a mounting surface (15) side in the plate thickness direction and then extends in the direction orthogonal to the plate thickness direction of the first wiring member (11).

According to the sixth aspect, the connection terminal (13) extends from the first wiring member (11) while being bent a plurality of times, and it is therefore possible to further increase the insulation distance.

In the power module according to any one of the fourth to sixth aspects, a seventh aspect of the present disclosure is arranged such that a plurality of wiring layers (50) each including the first wiring member (11) and the second wiring member (12) are provided apart from each other in the plate thickness direction.

According to the seventh aspect, the plurality of wiring layers (50) are provided apart from each other in the plate thickness direction, and therefore a space in the plate thickness direction can be effectively utilized, and a reduction in size of the module can be achieved.

In the power module according to any one of the first to seventh aspects, an eighth aspect of the present disclosure further includes a case (30) that covers the sealing material (36).

According to the eighth aspect, the sealing material (36) is covered with the case (30), and therefore the semiconductor element (2) can be protected.

In the power module according to any one of the first to seventh aspects, a ninth aspect of the present disclosure is arranged such that the sealing material (36) is made of a mold resin, and the holding member (20) is molded integrally with the sealing material (36).

According to the ninth aspect, the holding member (20) is molded integrally with the sealing material (36), and it is therefore unnecessary to provide the holding member (20) as a separate member, and a reduction in cost can be achieved.

A tenth aspect of the present disclosure is a semiconductor device including the power module (10) according to any one of the first to ninth aspects; a radiator (40) that is disposed in contact with the protruding portion (22) of the holding member (20); and a thermally conductive member (41) that has an insulating property and is disposed between the radiator (40) and the exposed surfaces (16) of the first wiring member (11) and the second wiring member (12).

According to the tenth aspect, it is possible to provide a semiconductor device including the power module (10), the radiator (40), and the thermally conductive member (41).

### Brief Description of Drawings

[Fig. 1] Fig. 1 is a side cross-sectional view illustrating a configuration of a power module according to the present embodiment 1.
[Fig. 2] Fig. 2 is a side cross-sectional view illustrating a configuration of a semiconductor device.
[Fig. 3] Fig. 3 is a side cross-sectional view for explaining a creepage distance for insulation according to a comparative example.
[Fig. 4] Fig. 4 is a side cross-sectional view for explaining a creepage distance for insulation in a case where a protruding portion is provided.
[Fig. 5] Fig. 5 is a side cross-sectional view illustrating a configuration of a protruding portion according to the present embodiment 2.
[Fig. 6] Fig. 6 is a side cross-sectional view illustrating a configuration of a protruding portion according to the present embodiment 3.
[Fig. 7] Fig. 7 is a side cross-sectional view illustrating a configuration of a protruding portion according to the present embodiment 4.
[Fig. 8] Fig. 8 is a side cross-sectional view illustrating a configuration of a connection terminal according to the present embodiment 5.
[Fig. 9] Fig. 9 is a side cross-sectional view illustrating a configuration of a connection terminal according to the present embodiment 6.
[Fig. 10] Fig. 10 is a side cross-sectional view illustrating a configuration of a connection terminal according to the present embodiment 7.
[Fig. 11] Fig. 11 is a side cross-sectional view illustrating a configuration of a power module according to the present embodiment 8.
[Fig. 12] Fig. 12 is a side cross-sectional view illustrating a configuration of a semiconductor device.
[Fig. 13] Fig. 13 is a side cross-sectional view illustrating a configuration of a power module according to the present embodiment 9.
[Fig. 14] Fig. 14 is a side cross-sectional view illustrating a configuration of a semiconductor device. Description of Embodiments

### <<Embodiment 1>>

### <Power Module>

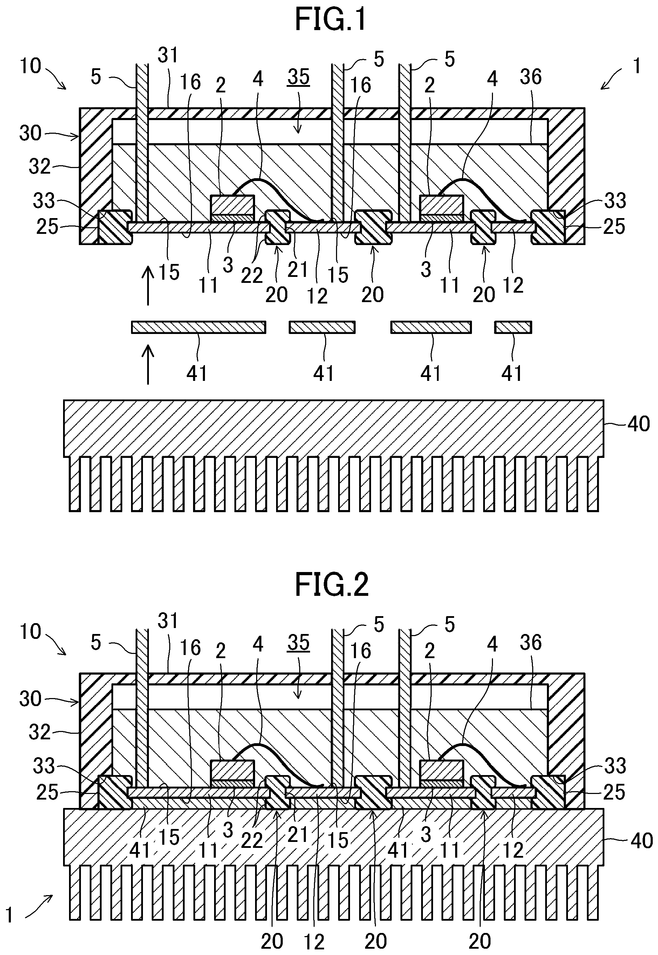

As illustrated in Figs. 1 and 2, a power module (10) includes a semiconductor element (2), a first wiring member (11), a second wiring member (12), a holding member (20), a case (30), and a sealing material (36).

The first wiring member (11) is a plate-shaped member having electric conductivity. The first wiring member (11) has a mounting surface (15) and an exposed surface (16) that is exposed on a side opposite to the mounting surface (15). The semiconductor element (2) is mounted on the mounting surface (15) by solder (3).

The second wiring member (12) is a plate-shaped member having electric conductivity. The second wiring member (12) is spaced apart from the first wiring member (11) in a direction orthogonal to a plate thickness direction of the first wiring member (11).

The second wiring member (12) has a mounting surface (15) and an exposed surface (16) that is exposed on a side opposite to the mounting surface (15). The exposed surface (16) of the second wiring member (12) is exposed on the same side as the exposed surface (16) of the first wiring member (11).

The semiconductor element (2) is, for example, an insulated gate bipolar transistor (IGBT), a diode, or the like. In the example illustrated in Fig. 1, two semiconductor elements (2) are provided. Each of the semiconductor elements (2) is connected to the second wiring member (12) by a wire (4).

One end of an external terminal (5) is electrically connected to each of the first wiring member (11) and the second wiring member (12). The other end of the external terminal (5) extends so as to protrude to an outside of the case (30). The other end of the external terminal (5) is connected to a control board (not illustrated).

The holding member (20) is an insulating member. The holding member (20) is disposed between the first wiring member (11) and the second wiring member (12). The holding member (20) holds the first wiring member (11) and the second wiring member (12).

The holding member (20) includes a holding portion (21) and a protruding portion (22). The holding portion (21) is disposed between the first wiring member (11) and the second wiring member (12). The protruding portion (22) is provided at both ends of the holding portion (21) in the up-down direction in Fig. 1. The protruding portions (22) are integral with the holding portion (21).

The protruding portion (22) on the lower side in Fig. 1 protrudes from the exposed surface (16) of the first wiring member (11) and the exposed surface (16) of the second wiring member (12) toward an exposed surface (16) side in the plate thickness direction. The protruding portion (22) on the upper side in Fig. 1 protrudes from the mounting surface (15) of the first wiring member (11) and the mounting surface (15) of the second wiring member (12) toward a mounting surface (15) side in the plate thickness direction.

The case (30) is, for example, an insulating resin member. The case (30) covers the mounting surface (15) of the first wiring member (11) and the mounting surface (15) of the second wiring member (12) so as to define an inner space (35). The sealing material (36) is sealed in the inner space (35) of the case (30). The sealing material (36) is covered with the case (30).

The case (30) includes an opposed portion (31) and a peripheral wall portion (32). The opposed portion (31) faces the mounting surface (15) of the first wiring member (11) and the mounting surface (15) of the second wiring member (12). The peripheral wall portion (32) extends toward the first wiring member (11) and the second wiring member (12) along a peripheral edge of the opposed portion (31). A stepped surface (33) is provided on an inner peripheral side of the peripheral wall portion (32) of the case (30).

The sealing material (36) includes an insulating material. The sealing material (36) is, for example, a resin material. The sealing material (36) covers the semiconductor element (2), the mounting surface (15) of the first wiring member (11), the mounting surface (15) of the second wiring member (12), and the wire (4).

A left end portion of the first wiring member (11) disposed at a left end in Fig. 1 and a right end portion of the second wiring member (12) disposed at a right end in Fig. 1 are each supported by an insulating member (25). The insulating member (25) protrudes from the exposed surface (16) of the first wiring member (11) and the exposed surface (16) of the second wiring member (12) toward the exposed surface (16) side in the plate thickness direction by the same length as the protruding portion (22) of the holding member (20). The insulating member (25) is in contact with the stepped surface (33) of the case (30).

In the power module (10) configured as above, heat generated by the semiconductor element (2) can be directly dissipated from the exposed surface (16) of the first wiring member (11). Furthermore, the presence of the protruding portions (22) makes it possible to secure a creepage distance for insulation between the first wiring member (11) and the second wiring member (12).

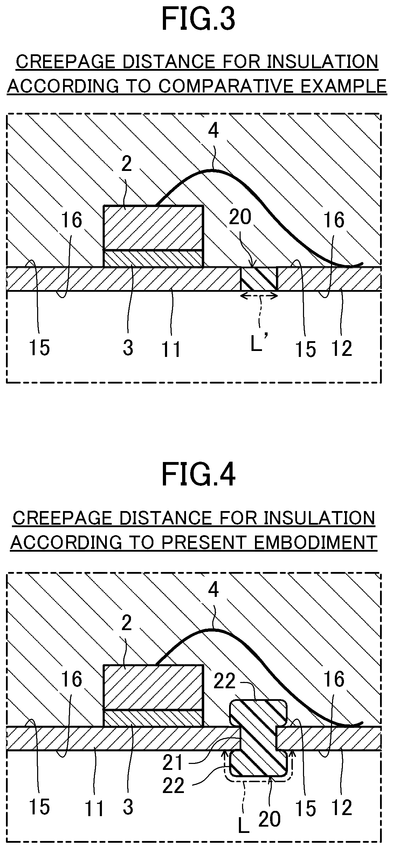

Specifically, in a comparative example illustrated in Fig. 3, the holding member (20) is not provided with the protruding portions (22), and a creepage distance for insulation L' between the first wiring member (11) and the second wiring member (12) is a length equal to a gap between the first wiring member (11) and the second wiring member (12).

On the other hand, as illustrated in Fig. 4, in a case where the holding member (20) is provided with the protruding portions (22), a creepage distance for insulation L between the first wiring member (11) and the second wiring member (12) is a length from the first wiring member (11) to the second wiring member (12) along an outer peripheral surface of the protruding portion (22), and L > L'.

### <Semiconductor Device>

As illustrated in Fig. 2, the semiconductor device (1) includes the power module (10), a radiator (40), and a thermally conductive member (41).

The radiator (40) is, for example, made of a thermally conductive material such as copper or aluminum. The radiator (40) is disposed in contact with the protruding portion (22) of the holding member (20) in the power module (10) and the insulating member (25). The power module (10) is, for example, fastened to the radiator (40) with a fastening screw (not illustrated).

The thermally conductive member (41) has an insulating property. The thermally conductive member (41) is, for example, grease. The thermally conductive member (41) is disposed between the radiator (40) and the exposed surfaces (16) of the first wiring member (11) and the second wiring member (12). In this case, a thickness of the thermally conductive member (41) can be set in accordance with a protruding amount of the protruding portion (22). The first wiring member (11) and the second wiring member (12) are thermally in contact with the radiator (40) with the thermally conductive member (41) interposed therebetween.

### - Effects of Embodiment 1 -

According to the features of the present embodiment, heat generated by the semiconductor element (2) is directly dissipated from the exposed surface (16) of the first wiring member (11). This can lower thermal resistance. Furthermore, the presence of the protruding portions (22) makes it possible to secure a creepage distance for insulation between the first wiring member (11) and the second wiring member (12).

According to the features of the present embodiment, the semiconductor element (2) can be protected by covering the sealing material (36) with the case (30).

According to the features of the present embodiment, it is possible to provide a semiconductor device including the power module (10), the radiator (40), and the thermally conductive member (41).

### <<Embodiment 2>>

In the following description, parts identical to those in Embodiment 1 described above are given identical reference signs, and only differences are described.

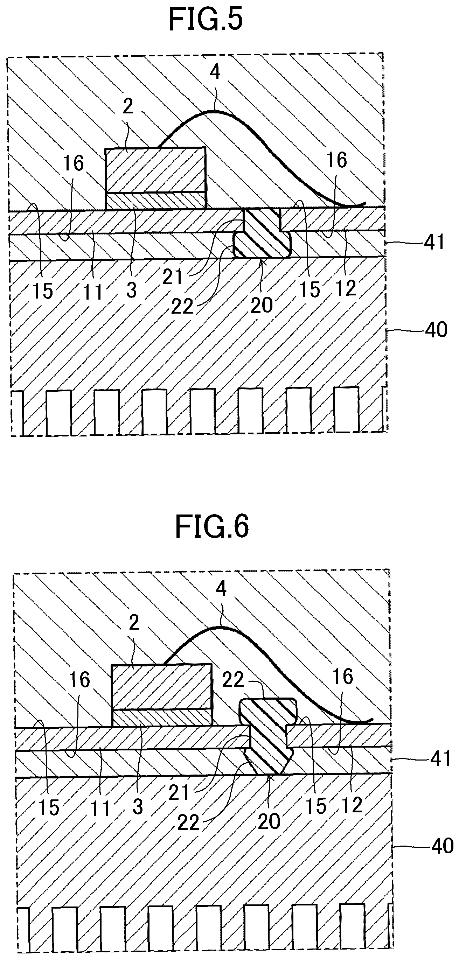

As illustrated in Fig. 5, a holding member (20) includes a holding portion (21) and a protruding portion (22). The holding portion (21) is disposed between a first wiring member (11) and a second wiring member (12). The protruding portion (22) is provided at an end portion of the holding portion (21) on the lower side in Fig. 1. The protruding portion (22) is integral with the holding portion (21).

The protruding portion (22) protrudes from an exposed surface (16) of the first wiring member (11) and an exposed surface (16) of the second wiring member (12) toward an exposed surface (16) side in a plate thickness direction.

On the other hand, the protruding portion (22) is not provided at an end portion of the holding portion (21) on the upper side in Fig. 1, and therefore an end portion of the holding member (20) on a side where the mounting surface (15) of the first wiring member (11) is located is flush with the mounting surface (15). Since the mounting surface (15) side of the first wiring member (11) and the mounting surface (15) side of the second wiring member (12) are sealed by the sealing material (36), a creepage distance for insulation between the first wiring member (11) and the second wiring member (12) can also be secured on the mounting surface (15) side.

### - Effects of Embodiment 2 -

According to the features of the present embodiment, it is possible to suppress occurrence of a situation where the holding member (20) causes a hindrance during wire bonding between the first wiring member (11) and the second wiring member (12). Furthermore, it is possible to reduce an amount of the holding member (20) used.

### <<Embodiment 3>>

As illustrated in Fig. 6, a holding member (20) includes a holding portion (21) and a protruding portion (22). The holding portion (21) is disposed between a first wiring member (11) and a second wiring member (12). The protruding portion (22) is provided at both ends of the holding portion (21) in the up-down direction in Fig. 1. The protruding portions (22) are integral with the holding portion (21).

The protruding portion (22) on the upper side in Fig. 1 protrudes from a mounting surface (15) of the first wiring member (11) and a mounting surface (15) of the second wiring member (12) toward a mounting surface (15) side in a plate thickness direction.

The protruding portion (22) on the lower side in Fig. 1 protrudes from an exposed surface (16) of the first wiring member (11) and an exposed surface (16) of the second wiring member (12) toward an exposed surface (16) side in the plate thickness direction. The protruding portion (22) on the lower side has a shape tapered toward a tip of the protruding portion (22).

### - Effects of Embodiment 3 -

According to the features of the present embodiment, heat generated by the semiconductor element (2) is dissipated so as to expand outward along the tapered shape of the protruding portion (22), and thereby thermal resistance can be lowered.

### <<Embodiment 4>>

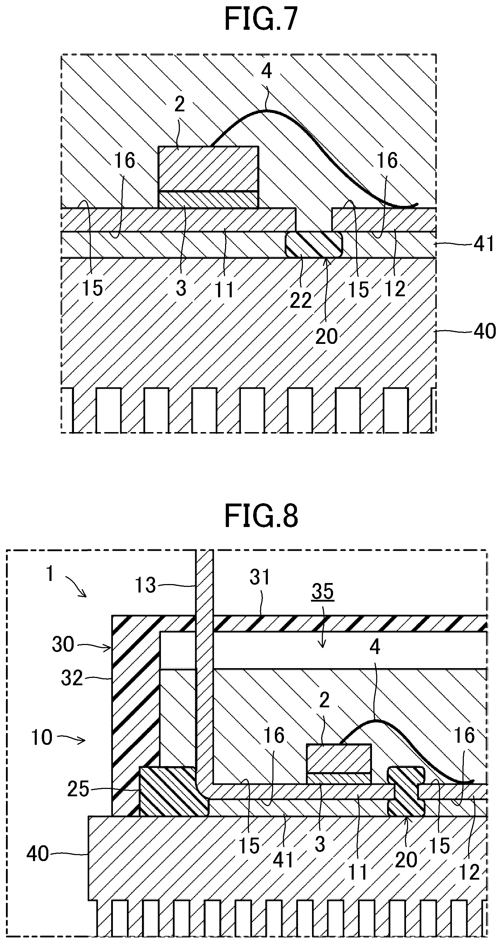

As illustrated in Fig. 7, a holding member (20) includes a protruding portion (22). The protruding portion (22) protrudes from an exposed surface (16) of a first wiring member (11) and an exposed surface (16) of a second wiring member (12) toward an exposed surface (16) side in a plate thickness direction. The protruding portion (22) is thus disposed on the exposed surface (16) side relative to a mounting surface (15) of the first wiring member (11) and a mounting surface (15) of the second wiring member (12).

### - Effects of Embodiment 4 -

According to the features of the present embodiment, it is possible to suppress occurrence of a situation where the holding member (20) causes a hindrance during wire bonding between the first wiring member (11) and the second wiring member (12). Furthermore, it is possible to reduce an amount of the holding member (20) used.

### <<Embodiment 5>>

As illustrated in Fig. 8, a first wiring member (11) includes a connection terminal (13). The connection terminal (13) is integral with the first wiring member (11). The connection terminal (13) extends in a plate thickness direction (the upward direction in Fig. 8) of the first wiring member (11). The connection terminal (13) penetrates an opposed portion (31) of a case (30). The connection terminal (13) is connected to a control board (not illustrated).

An insulating member (25) is provided on a side of the connection terminal (13) where the exposed surface (16) of the first wiring member (11) is located. The insulating member (25) supports the connection terminal (13). The insulating member (25) is in contact with a radiator (40).

### - Effects of Embodiment 5 -

According to the features of the present embodiment, the first wiring member (11) and the connection terminal (13) are integral, and it is therefore unnecessary to perform a step of connecting the first wiring member (11) and the connection terminal (13). This makes it possible to reduce the number of work steps.

### <<Embodiment 6>>

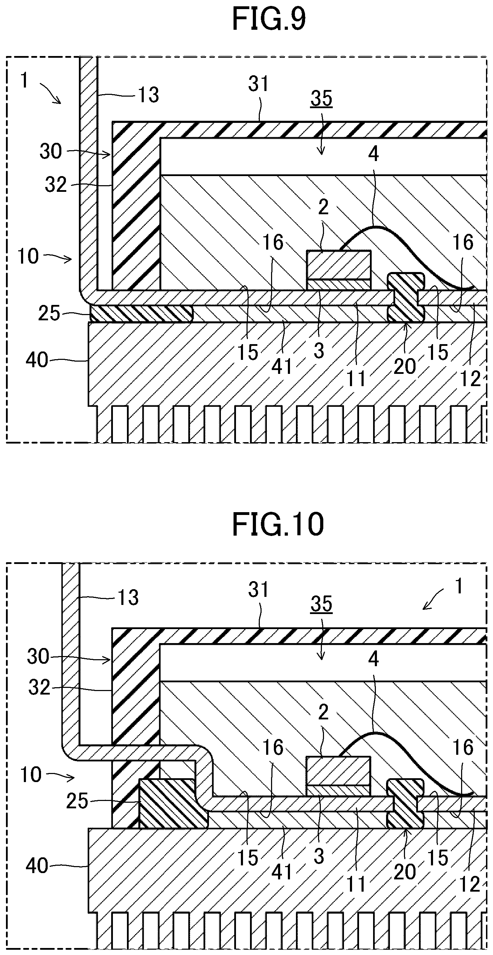

As illustrated in Fig. 9, a first wiring member (11) includes a connection terminal (13). The connection terminal (13) is integral with the first wiring member (11). The connection terminal (13) extends in a direction orthogonal to a plate thickness direction of the first wiring member (11). The connection terminal (13) penetrates a peripheral wall portion (32) of a case (30) and then extends in the plate thickness direction (upward direction in Fig. 9) of the first wiring member (11).

An insulating member (25) is provided on a side of the connection terminal (13) where an exposed surface (16) of the first wiring member (11) is located. The insulating member (25) supports the connection terminal (13). The insulating member (25) is in contact with a radiator (40).

### - Effects of Embodiment 6 -

According to the features of the present embodiment, the first wiring member (11) and the connection terminal (13) are integral, and it is therefore unnecessary to perform a step of connecting the first wiring member (11) and the connection terminal (13). This makes it possible to reduce the number of work steps.

According to the features of the present embodiment, even in the configuration in which the connection terminal (13) extends in a direction orthogonal to the plate thickness direction of the first wiring member (11), the presence of the insulating member (25) on the side of the connection terminal (13) where the exposed surface (16) of the first wiring member (11) is located makes it possible to secure an insulation distance between the connection terminal (13) and the radiator (40).

### <<Embodiment 7>>

As illustrated in Fig. 10, a first wiring member (11) includes a connection terminal (13). The connection terminal (13) is integral with the first wiring member (11). The connection terminal (13) extends from a mounting surface (15) of the first wiring member (11) toward a mounting surface (15) side in a plate thickness direction and then extends in a direction orthogonal to the plate thickness direction of the first wiring member (11). The connection terminal (13) penetrates a peripheral wall portion (32) of a case (30) and then extends in the plate thickness direction (upward direction in Fig. 10) of the first wiring member (11).

An insulating member (25) is provided on a side of the connection terminal (13) where an exposed surface (16) of the first wiring member (11) is located. The insulating member (25) supports the connection terminal (13). The insulating member (25) is in contact with a radiator (40).

### - Effects of Embodiment 7 -

According to the features of the present embodiment, the connection terminal (13) extends from the first wiring member (11) while being bent a plurality of times, and therefore an insulation distance between the connection terminal (13) and the radiator (40) can be further increased.

### <<Embodiment 8>>

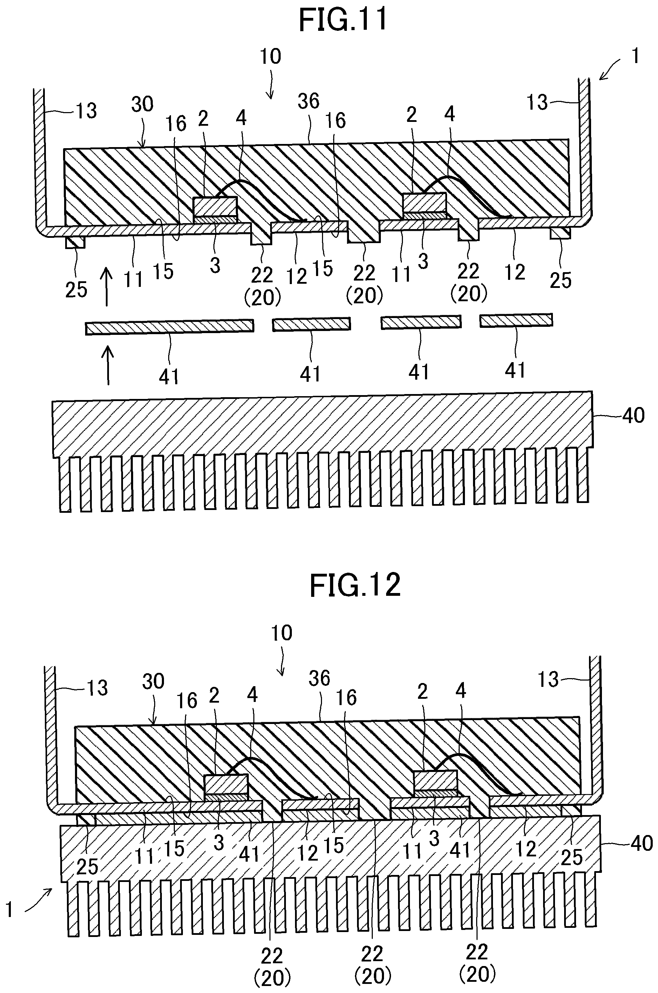

As illustrated in Figs. 11 and 12, a power module (10) includes a semiconductor element (2), a first wiring member (11), a second wiring member (12), a holding member (20), and a sealing material (36). The second wiring member (12) is spaced apart from the first wiring member (11) in a direction orthogonal to a plate thickness direction of the first wiring member (11).

The first wiring member (11) disposed at a left end in Fig. 11 includes a connection terminal (13). The connection terminal (13) is integral with the first wiring member (11). The connection terminal (13) extends in the plate thickness direction (upward direction in Fig. 11) of the first wiring member (11).

The second wiring member (12) disposed at a right end in Fig. 12 includes a connection terminal (13). The connection terminal (13) is integral with the second wiring member (12). The connection terminal (13) extends in a plate thickness direction (upward direction in Fig. 11) of the second wiring member (12).

The sealing material (36) is made of a mold resin. The sealing material (36) covers the semiconductor element (2), a mounting surface (15) of the first wiring member (11), a mounting surface (15) of the second wiring member (12), and a wire (4).

The holding member (20) is integral with the sealing material (36). Specifically, when the sealing material (36) is molded, the holding member (20) is formed integrally with the sealing material (36) by causing the sealing material (36) to protrude from a gap between the first wiring member (11) and the second wiring member (12).

The holding member (20) includes a protruding portion (22). The protruding portion (22) protrudes from an exposed surface (16) of the first wiring member (11) and an exposed surface (16) of the second wiring member (12) toward an exposed surface (16) side in the plate thickness direction.

### - Effects of Embodiment 8 -

According to the features of the present embodiment, the holding member (20) is molded integrally with the sealing material (36), and it is therefore unnecessary to provide the holding member (20) as a separate member, and it is possible to achieve a reduction in cost.

### <<Embodiment 9>>

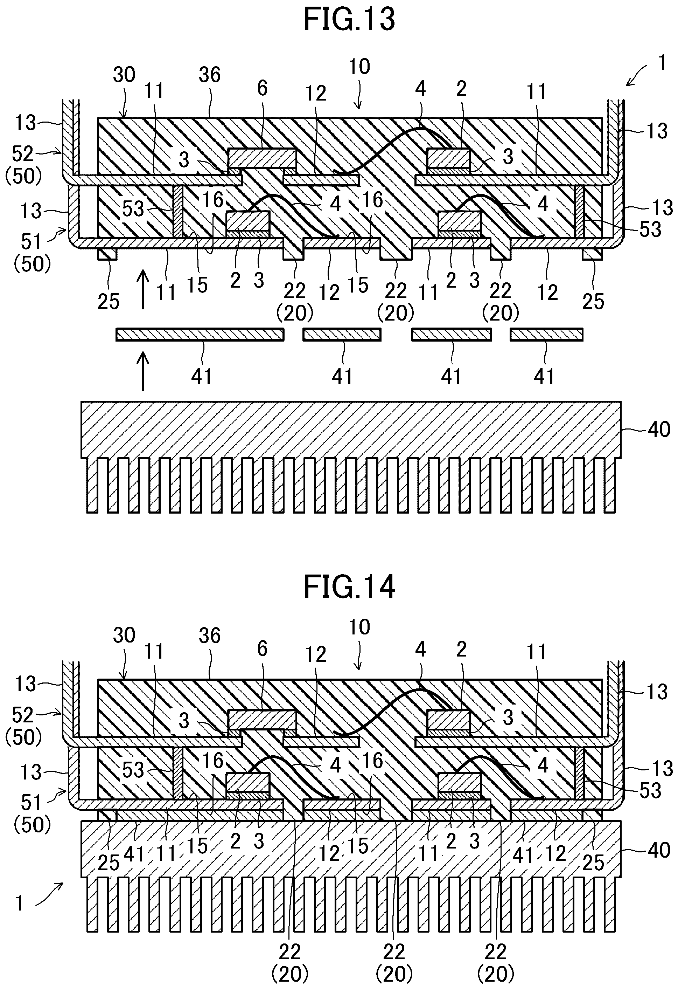

As illustrated in Figs. 13 and 14, a power module (10) includes a plurality of wiring layers (50). The plurality of wiring layers (50) are spaced apart from each other in a plate thickness direction. The wiring layers (50) include a first wiring layer (51) and a second wiring layer (52).

The first wiring layer (51) includes a first wiring member (11), a second wiring member (12), a semiconductor element (2), and a wire (4). The first wiring member (11) and the second wiring member (12) each include a connection terminal (13).

The second wiring layer (52) includes a first wiring member (11), a second wiring member (12), a semiconductor element (2), an electronic component (6), and a wire (4). The first wiring member (11) and the second wiring member (12) each include a connection terminal (13).

The electronic component (6) is, for example, a resistor, a capacitor, an inductor, a thermistor, or the like. The electronic component (6) is electrically connected across the first wiring member (11) and the second wiring member (12) by solder (3).

The first wiring member (11) or the second wiring member (12) of the first wiring layer (51) and the first wiring member (11) or the second wiring member (12) of the second wiring layer (52) are electrically connected by an electrically conductive member (53).

A mounting surface (15) side of the first wiring layer (51) and a mounting surface (15) side and an exposed surface (16) side of the second wiring layer (52) are sealed by a sealing material (36). The sealing material (36) is made of a mold resin. The sealing material (36) is not provided on an exposed surface (16) side of the first wiring layer (51), and the exposed surface (16) of the first wiring layer (51) is exposed.

A holding member (20) is molded integrally with the sealing material (36). Specifically, the holding member (20) is formed integrally with the sealing material (36) by causing the sealing material (36) to protrude from a gap between the first wiring member (11) and the second wiring member (12) when the sealing material (36) is molded.

The holding member (20) includes a protruding portion (22). The protruding portion (22) protrudes from the exposed surface (16) of the first wiring member (11) and the exposed surface (16) of the second wiring member (12) toward the exposed surface (16) side in the plate thickness direction.

### - Effects of Embodiment 9 -

According to the features of the present embodiment, the plurality of wiring layers (50) are provided apart from each other in the plate thickness direction, and therefore a space in the plate thickness direction can be effectively utilized, and a reduction in size of the module can be achieved.

### <<Other Embodiments>>

Although the embodiments and modifications have been described above, it will be understood that various changes in form and details may be made without departing from the spirit and scope of the claims. Further, the elements in the above embodiments, modifications, and other embodiments may be appropriately combined or substituted. The expressions "first", "second", "third" and so on in the specification and the claims are used to distinguish terms to which these expressions are assigned, and do not limit the number or order of those terms.

### Industrial Applicability

As described above, the present disclosure is useful for a power module and a semiconductor device.

### Reference Signs List

- 1: semiconductor device
- 2: semiconductor element
- 10: power module
- 11: first wiring member
- 12: second wiring member
- 13: connection terminal
- 15: mounting surface
- 16: exposed surface
- 20: holding member
- 22: protruding portion
- 25: insulating member
- 30: case
- 36: sealing material
- 40: radiator
- 41: thermally conductive member
- 50: wiring layer

## Claims

1. A power module comprising:
a semiconductor element (2);
a first wiring member (11) that is a plate-shaped member having electric conductivity and has a mounting surface (15) on which the semiconductor element (2) is mounted and an exposed surface (16) exposed on a side opposite to the mounting surface (15);
a second wiring member (12) that is a plate-shaped member having electric conductivity, is spaced apart from the first wiring member (11) in a direction orthogonal to a plate thickness direction of the first wiring member (11), and has an exposed surface (16) exposed on a same side as the exposed surface (16) of the first wiring member (11);
a holding member (20) that has an insulating property, is disposed between the first wiring member (11) and the second wiring member (12), holds the first wiring member (11) and the second wiring member (12), and includes a protruding portion (22) that protrudes from the exposed surface (16) toward an exposed surface (16) side in the plate thickness direction; and
a sealing material (36) that has an insulating property and covers at least the semiconductor element (2), the mounting surface (15) of the first wiring member (11), and the mounting surface (15) of the second wiring member (12).

2. The power module according to claim 1, wherein
an end portion of the holding member (20) on a side where the mounting surface (15) of the first wiring member (11) is located is flush with the mounting surface (15) or is disposed on the exposed surface (16) side relative to the mounting surface (15).

3. The power module according to claim 1 or 2, wherein
the protruding portion (22) has a shape tapered toward a tip of the protruding portion (22).

4. The power module according to any one of claims 1 to 3, further comprising a connection terminal (13) that is integral with the first wiring member (11).

5. The power module according to claim 4, wherein
the connection terminal (13) extends in the direction orthogonal to the plate thickness direction of the first wiring member (11), and
the power module further comprises an insulating member (25) that is provided on a side of the connection terminal (13) where the exposed surface (16) of the first wiring member (11) is located.

6. The power module according to claim 4, wherein
the connection terminal (13) extends from the mounting surface (15) of the first wiring member (11) toward a mounting surface (15) side in the plate thickness direction and then extends in the direction orthogonal to the plate thickness direction of the first wiring member (11).

7. The power module according to any one of claims 4 to 6, wherein
a plurality of wiring layers (50) each including the first wiring member (11) and the second wiring member (12) are provided apart from each other in the plate thickness direction.

8. The power module according to any one of claims 1 to 7, further comprising a case (30) that covers the sealing material (36).

9. The power module according to any one of claims 1 to 7, wherein
the sealing material (36) is made of a mold resin, and
the holding member (20) is molded integrally with the sealing material (36).

10. A semiconductor device comprising:
the power module (10) according to any one of claims 1 to 9;
a radiator (40) that is disposed in contact with the protruding portion (22) of the holding member (20); and
a thermally conductive member (41) that has an insulating property and is disposed between the radiator (40) and the exposed surfaces (16) of the first wiring member (11) and the second wiring member (12).
